Europäisches Patentamt

European Patent Office

Office européen des brevets

(11) Numéro de publication: **0 300 873**
**A1**

## DEMANDE DE BREVET EUROPÉEN

(21) Numéro de dépôt: 88401784.9

(22) Date de dépôt: 08.07.88

(51) Int. Cl.⁴: **B 23 K 1/00**
H 01 L 21/00
// B23K26/00

(30) Priorité: 24.07.87 FR 8710572

(43) Date de publication de la demande:
25.01.89 Bulletin 89/04

(84) Etats contractants désignés:
CH DE FR GB IT LI NL

(71) Demandeur: **THOMSON COMPOSANTS MILITAIRES ET SPATIAUX**
**173, Bd Haussmann**
**F-75008 Paris (FR)**

(72) Inventeur: **Mermet-Guyennet, Michel**
**THOMSON-CSF SCPI - 19, avenue de Messine**
**F-75008 Paris (FR)**

(74) Mandataire: **Guérin, Michel et al**
**THOMSON-CSF SCPI 19, avenue de Messine**
**F-75008 Paris (FR)**

(54) Four de soudure de puces de circuit intégré.

(57) La présente invention a pour objet un four de soudure de puces de circuit intégré sur un substrat céramique, comprenant une plaque chauffante (3) supportant le substrat (12), la plaque comportant des perçages (8) aux endroits où seront soudées les puces de circuit intégré, à l'arrière de la plaque, une source de rayonnement thermique (11) et des moyens (15) pour diriger le rayonnement au choix sur un seul à la fois des trous de la plaque.
Application à la microélectronique.

FIG. 1

EP 0 300 873 A1

Bundesdruckerei Berlin

## Description

## FOUR DE SOUDURE DE PUCES DE CIRCUIT INTEGRE

L'invention concerne un four de soudure de puces de circuit intégré. Elle concerne plus particulièrement un four permettant de souder des puces sur un substrat céramique de circuit hybride.

Jusqu'ici on a procédé à la soudure de puces de circuit intégré uniquement dans leur boîtier. Pour cela on place le boîtier dans un four qui comporte des résistances de chauffage. On met en place une préforme eutectique dans le boîtier à l'endroit où doit être soudée la puce. On fait monter la température du four, jusqu'à ce que la préforme atteigne la température de fusion. La puce de circuit intégré est placée dans le boîtier sur la préforme et le chauffage est arrêté. La préforme en se refroidissant permet de fixer mécaniquement la puce au boîtier. Pour retirer la puce du boîtier on procède à la même opération afin de porter la préforme à sa température de fusion.

On est amené de plus en plus à utiliser des circuits hybrides. Les circuits hybrides sont constitués par un ensemble de circuits intégrés et autres composants disposés sur un seul substrat. Les puces sont habituellement collées sur le substrat. Or la technique qui consiste à coller les puces n'est pas fiable dans le temps. D'autre part, la colle ne permet pas d'obtenir une bonne dissipation thermique. Cependant, il est impossible d'utiliser la technique de soudure eutectique à des circuits hybrides car le matériel existant ne permet pas, d'une part de recevoir de tels circuits, et d'autre part de pratiquer la soudure de toutes les puces en même temps. Or si l'on procède à la soudure d'une puce après l'autre, les préformes déjà en place atteignent leur température de fusion et les puces se désolidarisent au fur et à mesure de leur mise en place. Par ailleurs, il n'est pas possible non plus, en cas de défectuosité d'une puce, de déssouder cette puce sans perturber toutes les autres.

Il existe cependant une technique utilisée pour effectuer des soudures tendres et dans laquelle on procède à un passage dans un four à convoyeur, cependant la mouillabilité est trop médiocre et de ce fait ne convient pas et d'autre part le positionnement que l'on peut obtenir pour les circuits est très insuffisant.

La présente invention permet de remédier à tout ces problèmes en proposant un four qui comporte un châssis chauffant et un dispositif d'apport localisé de chaleur, cet ensemble permettant d'effectuer les soudures des puces une à une sans perturbation des puces déjà soudées.

La présente invention a plus particulièrement pour objet un four de soudure de puces de circuit intégré sur un substrat céramique, comprenant une plaque chauffante supportant le substrat, la plaque comportant des perçages aux endroits où seront soudées les puces de circuit intégré, à l'arrière de la plaque, une source de rayonnement thermique et des moyens pour diriger le rayonnement au choix sur un seul à la fois des trous de la plaque.

L'invention sera mieux comprise à l'aide de la description effectuée à titre d'exemple non limitatif en regard des schémas annexés dans lesquels :
- la figure 1, représente un four de soudure selon l'invention ;
- la figure 2, représente le détail du châssis et de la plaque chauffante du four selon l'invention ;
- la figure 3, représente une cartographie des températures d'un substrat, selon l'invention.

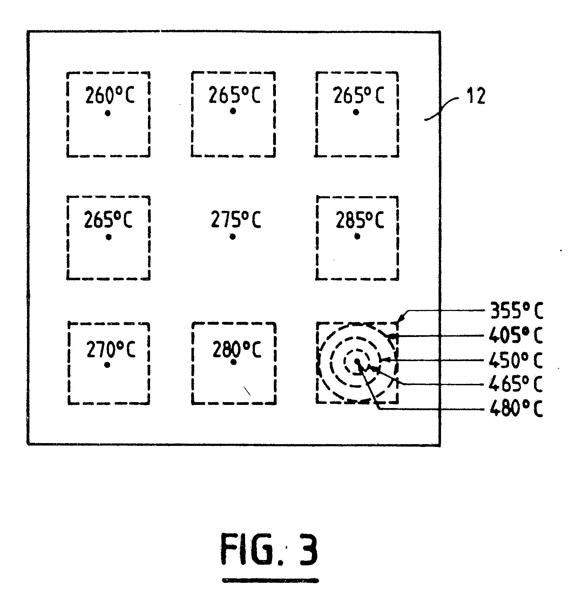

- la figure 3, repreésemte ime cartpgra[joe des températures d'un substrat, selon l'invention.

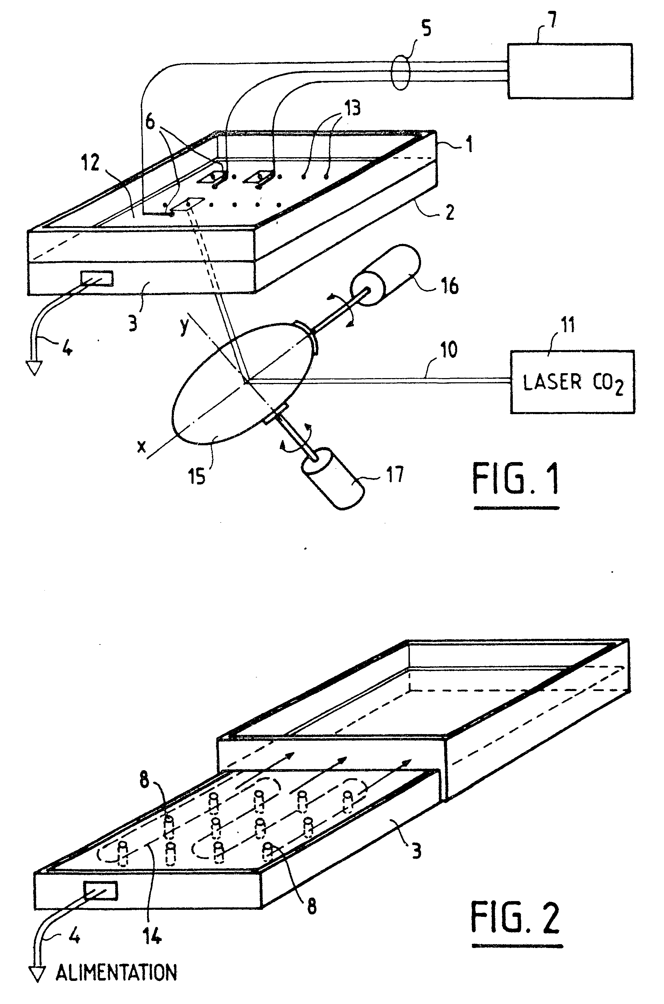

La figure 1, représente un schéma d'un four selon l'invention. Le four comporte un châssis 1, comprenant dans le fond 2 une plaque chauffante 3, de préférence amovible. Cette plaque renferme des résistances chauffantes 14 visibles sur la figure 2, qui sont reliées électriquement à une alimentation secteur, par un câble 4 connecté à la plaque. Un deuxième câble 5 connecté au chassis du four permet de relier électriquement des thermocouples 6 à un circuit de commande électronique 7 pour commander le réglage du chauffage par les résistances. Comme cela est représenté sur la figure 2, la plaque 3 du fond du four a été percée de manière à comporter un nombre défini d'ouvertures 8 de faibles diamètres, calibrées pour laisser passer le rayonnement d'une source thermique placée à l'arrière de cette plaque. Ce rayonnement peut être produit par un faisceau laser 10 dont le diamètre a été choisi à titre d'example pour l'étude de faisabilité d'environ 4mm de diamètre, obtenu à partir d'une source laser 11. On peut en fait faire une adaptation de la grosseur du faisceau sur le substrat en utilisant la divergence du laser. D'autre part, la distribution d'énergie sur le faisceau est adoptée à partir des modes de rayonnement (TEM 00, TEM 01,..., Multimode).Le nombre d'ouvertures correspond au nombre de puces qui doivent être soudées sur le substrat. Pour un nombre donné de puces, on utilisera la plaque correspondante qui comportera le nombre voulu d'ouvertures et dont l'emplacement correspondra à celui des puces sur le substrat.

Le substrat 12 est mis en place dans le four sur la plaque chauffante 3 et est câlé de sorte que l'emplacement réservé aux puces se trouve en vis-à-vis avec les ouvertures de la plaque. Le substrat 12 comporte également un ou plusieurs trous 13 de petite dimension aux emplacements où sont soudés les pastilles de préforme. Ces trous permettent de laisser passer une pointe dans l'éventualité d'une réparation pour éjecter la pastille avec la puce. La dimension des trous doit être suffisante pour pouvoir laisser passer une pointe mais assez petite pour ne pas engendrer de trop grand gradient de contraintes dans le silicium après soudure.

Lorsqu'on procède à la soudure des puces sur le substrat, on met en place des préformes eutectiques se présentant sous forme de pastilles constituées par exemple d'un alliage d'or et de silicium ou d'or et de germanium ou autre alliage adapté. On effectue ensuite un préchauffage au moyen des résistances 14 pour que la température sur le substrat se stabilise à une température prédéterminée, qui correspond à une température de régulation. Lorsque cette température est atteinte, on oriente le faisceau laser 10 de sorte que le rayonnement de ce faisceau arrive en dessous de la plaque du four et atteigne l'ouverture désirée de cette plaque pour élever localement la température du substrat. Ainsi la température de la préforme, qui est placée au desssus du substrat, croît également jusqu'à atteindre la température eutectique. Lorsque la température eutectique est atteinte, la préforme fond, la puce est mise en place au dessus de la préforme en fusion et l'émission du faisceau laser est arrêtée. La préforme en se refroidissant se durcit et fixe mécaniquement la puce au substrat. On recommence, cette opération pour chaque puce à souder sur le substrat.

Pour effectuer l'apport localisé de chaleur on utilise selon cet exemple un dispositif laser 11 à gaz carbonique émettant un rayonnement continu qui est par exemple d'une puissance de 15W. L'énergie du laser peut bien entendu être réglée en fonction de la pastille à souder et de la capacité d'absorption du substrat à la longueur d'onde condidérée. On peut également utiliser à la place d'un rayonnement laser, une lampe de type Xenon, un jet de gaz chaud, ou tout autre moyen de transport d'énergie calorifique par rayonnement ou convection.
Pour orienter le faisceau laser vers une ouverture donnée de la plaque, on utilise un miroir réflechissant 15, incliné d'un angle tel que ce faisceau réfléchi soit situé exactement sous cette ouverture.

Bien entendu, ce miroir peut être commandé mécaniquement pour obtenir une inclinaison autour d'un axe X et une inclinaison autour d'un axe Y de manière à donner au faisceau les coordonnées en X et Y désirées.

Dans le but d'obtenir la position désirée du faisceau, le miroir est par exemple solidaire d'un axe X couplé à un petit moteur 16, et solidaire d'un axe Y couplé à un autre petit moteur 17.

Le miroir peut selon un mode préféré de réalisation être fixe par rapport à un repère, le four étant alors mobile au dessus du miroir par rapport à ce repère. Le positionnement du four est par conséquent obtenu par des déplacements suivant deux axes orthogonaux qui peuvent être réalisés par des mécanismes adaptés du domaine de l'état de la technique. Cette solution s'adapte bien à une automatisation, car dans ce cas, le système de prise et d'amenée de la puce et de la préforme peut être solidaire du four ainsi que le système d'éjection des pastilles de préforme avec la puce, par des pointes.

Un tel four permet de souder plusieurs puces de circuit intégré sur un substrat, les unes après les autres sans perturbation sur les puces déjà mises en place sur le substrat.

Le four permet également, lorsque cela s'avère nécessaire, de désolidariser une puce du substrat sans perturber toutes les autres. Pour cela on replace le substrat avec les circuits intégrés dans le four, pour amener ce substrat à la température de régulation de 200° C par mise en fonction des résistances du four, puis on positionne le miroir ou le four pour que le faisceau laser se trouve sous l'ouverture de la plaque du four qui se trouve en dessous de la puce à ôter. On met en fonction le dispositif laser, la préforme placée entre la puce et le substrat subit une augmentation de température. Lorsque la température atteint la température eutectique, il suffit de saisir la puce ou de la soulever pour la retirer. On peut, par exemple à l'aide d'une pointe soulever la puce, en glissant cette pointe dans les ouvertures de la plaque et du substrat, les ouvertures 13 de faibles diamètres pratiquées dans le substrat étant prévues à cet effet.

L'alliage des préformes or-germanium ou autre alliage adapté à cette fonction, permet de supporter plusieurs fusions sans qu'il y ait d'altération de ses qualités de mouillabilité sur la face arrière des circuits intégrés qui se trouvent en contact avec la préforme.

Le substrat est par exemple un substrat en alumine ou en nitrure d'aluminium qui s'adapte bien au chauffage localisé par laser $CO_2$.

Sur la figure 2, on a représenté un exemple de résultat obtenu pour un substrat 12 en alumine de deux pouces (soit 50,8 mm sur 50,8 mm), un laser de puissance 15 W, un diamètre du faisceau sous le substrat de 4 mm et une température de régulation de 260°. La température du substrat dans la région centrale s'élève jusqu'à 480° C cette température étant supérieure à la température eutectique.

Cette température diminue au fur et à mesure que l'on s'éloigne de l'impact du faisceau pour atteindre une valeur de 355° C correspondant à une température légèrement supérieure ou égale à la température eutectique.

Les autres zones du substrat sur lesquelles sont placées les puces ne dépassent pas une température de 285° C, cette température étant nettement inférieure à la température eutectique.

**Revendications**

1. Four de soudure de puces de circuit intégré sur un substrat céramique, caractérisé en ce qu'il comprend une plaque chauffante (3) supportant le substrat (12), la plaque comportant des perçages (8) aux endroits où seront soudées les puces de circuit intégré, et en ce qu'il comprend à l'arrière de la plaque une source de rayonnement thermique (11) et des moyens (15) pour diriger le rayonnement au choix sur un seul à la fois des trous de la plaque.

2. Four de soudure selon la revendication 1, caractérisé en ce que la source de rayonnement (11) est constituée par un laser à gaz carbonique et les moyens pour diriger le rayonnement sont constitués par un miroir réfléchissant (15).

3. Four de soudure selon la revendication 1 ou 2, caractérisé en ce que le substrat (12) placé sur la plaque chauffante comporte des perçages (13) en vis-à-vis avec les perçages de la plaque pour permettre le passage d'une pointe afin de soulever la puce à dessouder.

4. Four de soudure selon l'une quelconque des revendications 1 à 3, caractérisé en ce que le four est fixe par rapport à un repère et en ce que le miroir est mobile par rapport à ce repère.

5. Four de soudure selon l'une quelconque des revendications 1 à 3, caractérisé en ce que le miroir est fixe par rapport à un repère et en ce que le four est mobile par rapport à ce repère.

0300873

FIG. 1

LASER CO$_2$

ALIMENTATION

FIG. 2

FIG. 3

## DOCUMENTS CONSIDERES COMME PERTINENTS

| Catégorie | Citation du document avec indication, en cas de besoin, des parties pertinentes | Revendication concernée | CLASSEMENT DE LA DEMANDE (Int. Cl.4) |
|---|---|---|---|
| Y | EP-A-0 013 345 (INTERNATIONAL BUSINESS MACHINES) <br> * Page 6, lignes 13-26; page 9, ligne 29 - page 10, ligne 12; page 11, ligne 33 - page 12, ligne 11; figures 1,2 * | 1,2,4,5 | B 23 K 1/00 <br> H 01 L 21/00 // <br> B 23 K 26/00 |
| Y | US-A-3 742 181 (B.J. COSTELLO) <br> * Colonne 3, ligne 22 - colonne 4, ligne 11; colonne 4, ligne 38 - colonne 5, ligne 65; figure 1 * | 1,2,4,5 | |
| A | IBM TECHNICAL DISCLOSURE BULLETIN, vol. 16, no. 4, septembre 1973, page 1154, New York, US; W.R. DE BOSKEY et al.: "Accurate chip placement on a substrate" <br> * En entier * | 3 | |
| A | PATENT ABSTRACTS OF JAPAN, vol. 10, no. 368 (M-543)[2425], 9 décembre 1986, page 55 M 543; & JP-A-61 162 292 (YUTAKA KANEDA) 22-07-1986 <br> * En entier * | 1 | DOMAINES TECHNIQUES RECHERCHES (Int. Cl.4) |
| A | EP-A-0 109 892 (PIEZO-CERAM ELECTRONIQUE) <br> * Abrégé * | 1 | B 23 K <br> H 01 L |
| A | US-A-4 634 043 (M.K. AVEDISSIAN) <br> * Colonne 4, lignes 29-62; figure 1 * | 3 | |
| A | DE-A-2 360 308 (MISHINA KOSAN) <br> * Page 3; figures 1,5,6 * | 2 | |

Le présent rapport a été établi pour toutes les revendications

| Lieu de la recherche | Date d'achèvement de la recherche | Examinateur |
|---|---|---|
| LA HAYE | 31-10-1988 | ARAN D.D. |